# EUROPEAN PATENT APPLICATION

(11) **EP 3 130 559 A1**
(43) Date of publication of application: **15.02.2017**
(21) Application number: 15002432.1
(22) Date of filing: 14.08.2015
(51) Int. Cl.: B81C 1/00, B82Y 10/00, B82Y 40/00, G02B 1/118, H01L 21/3065, H01L 21/308

(54) **FABRICATION OF NANOSTRUCTURED SUBSTRATED COMPRISING A PLURALITY OF NANOSTRUCTURE GRADIENTS ON A SINGLE SUBSTRATE**

(71) Applicant: Max-Planck-Gesellschaft zur Förderung der Wissenschaften e.V., 80539 München (DE)
(72) Inventor: Diao, Zhaolu, 70195 Stuttgart (DE); Dirks, Jan-Henning, 70563 Stuttgart (DE); Spatz, Joachim P., 70569 Stuttgart (DE)
(74) Representative: v. Bezold & Partner Patentanwälte - PartG mbB

(57) **Abstract**

The invention relates to a method for producing a nanostructured substrate comprising an array of protruding nanostructures, which method comprises at least the following steps:
a) providing a primary substrate;
b) depositing at least one layer of a material capable to be removed by means of reactive ion etching (RIE) onto said primary substrate which layer comprises a predetermined gradient of its thickness;
c) depositing a nanostructured etching mask onto the graded layer deposited in step b);
d) generating protruding structures, in particular nanopillars, in the graded layer deposited in step b) by means of reactive ion etching (RIE), wherein simultaneously at least 2, preferably 3, predetermined continuous gradients of geometric parameters of the protruding structures are generated on the same substrate.

More specifically, the geometric parameters are selected from the group comprising the height, diameter and spacing of the protruding nanostructures.

A further aspect of the invention relates to a nanostructured substrate comprising an array of protruding nanostructures obtainable by the method as outlined above.

In a preferred embodiment of said nanostructured substrate, each of the protruding nanostructures simultaneously represents an element of 3 continuous gradients of the height, diameter and spacing of said protruding nanostructures.

## Description

### Background

Several methods for generating nanostructures on various substrate surfaces, e.g. by means of electron beam lithography or various etching techniques, are known in the art. Such nanostructures may be, e.g., used for immobilizing target entities such as biomolecules or for providing antireflective coatings on the respective substrates.

Typically, antireflective coatings are made from various types of thin layers. These antireflective layers however are only effective within a limited rage of wavelengths, usually allow only slight changes of angles of incidence and are very difficult to tune to required specifications of transmission or reflection. Moth-eye like nanostructures (MOES) can solve many of these problems, showing an almost wavelength independent high transmission rate combined with a very low reflection (Morhard, C., Nanolithographie, 1-149 (2010); Brunner et al., Applied Optics 52, 4370-4376 (2012)).

Although the MOES are very effective across a wide range of wavelengths, a characteristic feature of MOES structures are local ultra-low reflection minima at certain wavelengths (Ma et al., in Optica Acta: international Journal of Optics 30, 1685-1695 (2010)). These local minima are a physical result of the so called "Fabry-Pérot effect", where constructive and destructive interference between the multiple reflections of light create a characteristic interference pattern with ultra low reflection. The wavelength at this local reflection minimum is thus determined by the geometry of the pillars (height, spacing, shape). Hence, the use of this local Fabry-Pérot reflection minimum in optical system is thus limited to one wavelength per pillar geometry.

To manufacture substrates with different pillar geometries, typically a combination of BCML and RIE etching is used (see WO 2012048870 A3, EP 2295617 and EP 1244938 for further details).

Using the BCML technology in combination with for example electroless deposition and dip-coating setups, it is possible to manufacture gold-dot patterns with varying size and distances. These methods, however, do not allow to independently and simultaneously control and generate more than one parameter of the pillar geometry on a single substrate without introducing additional complex masking and etching procedures (Özdemir, B. et al., Nanotechnology, 26(11), 1-7, (2015). It is also not possible to obtain continuous gradients with the approach of Ozdemir et al.

To change the position of the Fabry-Pérot minimum, one thus has to replace the moth-eye substrate, or filter, with a substrate covered by a different pillar geometry. This replacement procedure is very complex and can cause severe problems regarding re-alignment of the optical path, sensor alignment, comparability between different filters, etc.

It was therefore an object of the present invention to provide single nanostructured substrates, in particular moth-eye substrates, exhibiting a plurality of gradients of the characteristic geometric parameters of said nanostructures, in particular antireflective nanostructures, and methods for preparing the same which overcome the above drawbacks of the prior art.

This object is achieved according to the invention with the provision of the method according to Claim 1 and the nanostructured substrate according to Claim 10. Specific or preferred embodiments and aspects of the invention are the subject matter of the further claims.

### Description of the invention

The method according to the invention for producing a nanostructured substrate comprising an array of protruding nanostructures, in particular nanopillars, comprises at least the following steps:
a) providing a primary substrate;
b) depositing at least one layer of a material capable to be removed by means of reactive ion etching (RIE) onto said primary substrate which layer comprises a predetermined gradient of its thickness;
c) depositing a nanostructured etching mask onto the graded layer deposited in step b);
d) generating protruding structures, in particular nanopillars, in the graded layer deposited in step b) by means of reactive ion etching (RIE), wherein simultaneously at least 2, preferably 3, predetermined continuous gradients of geometric parameters of the protruding structures are generated on the same substrate.

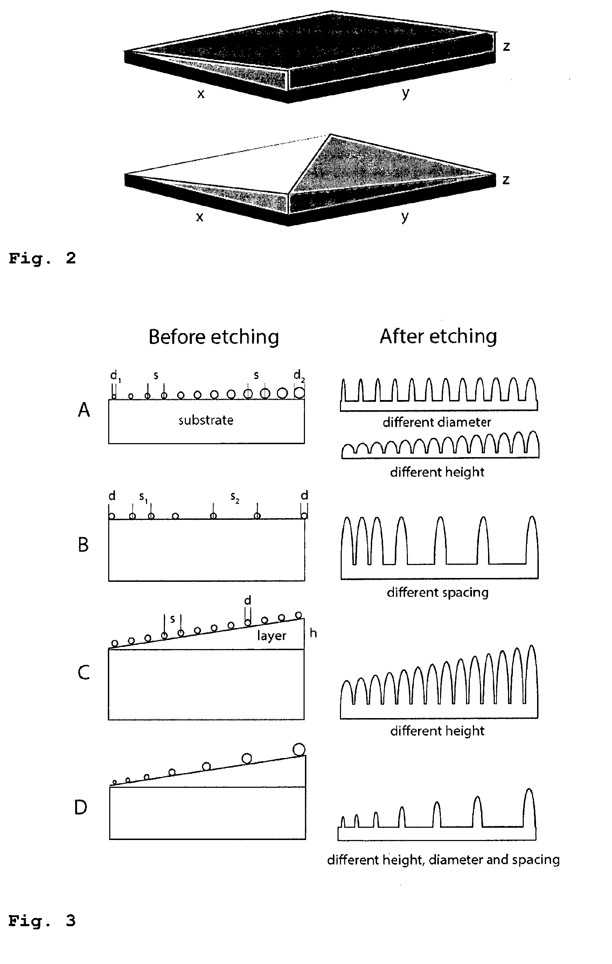

More specifically, the thickness gradient of the layer deposited in step b) above may be a gradient in one or more directions, such as a 2-dimensional or 3-dimensional gradient. The term "a 2-dimensional gradient of thickness", as used herein, refers to a gradient in the direction of the x-axis or y-axis of a substrate (e.g., as depicted in Fig. 2, top), whereas "a 3-dimensional gradient" comprises at least one further thickness gradient, preferably in the direction of the other axis of the substrate (e.g., as depicted in Fig. 2, bottom).

Typically, the geometric parameters of the protruding structures are selected from the group comprising the height, diameter and spacing of the protruding structures.

In a preferred embodiment of the method of the invention, each of the resulting protruding nanostructures simultaneously represents an element of 3 continuous gradients of the height, diameter and spacing of said protruding nanostructures.

The superposition of several gradients of the geometric parameters may also be termed a gradient of higher order, such as a 2-dimensional or 3-dimensional gradient.

The term "continuous gradient" is meant to denote a gradient which does not comprise any discontinuous alterations ("steps") of the respective geometric parameter and as such in particular does not comprise so-called step gradients.

Advantageously, the material of the primary substrate is not especially limited and may be selected from a wide range of organic and inorganic substrates.

In one specific embodiment, the material of the primary substrate is selected from organic or inorganic glasses.

More specifically, the material may comprise one of the following base systems of inorganic glasses with their main components: 1) B₂O₃ - La₂O₃ - MₘOₙ (m being an integer from 1 to 2 and n being an integer from 2 to 5; MₘOₙ preferably selected from ZrO₂, Ta₂O₅, Nb₂O₅, Gd₂O₃, Y₂O₃, TiO₂, WO₃); 2) (B₂O₃, SiO₂)-La₂O₃ - MO, MO being a metal oxide typically selected from MgO, CaO, SrO, BaO, ZnO; 3) SiO₂ - PbO - M₂O with (for example) M₂O selected from Li₂O, Na₂O, K₂O, Ca₂O; the PbO content in glasses of the system SiO₂ - PbO - M₂O can be replaced partially or completely by TiO₂; 4) SiO₂ - B₂O₃ - BaO; 5) (SiO₂, B₂O₃) - BaO-PbO; 6) SiO₂ - M₂O - TiO₂ (preferably the glass lattice/matrix comprises additional molecules, atoms, or ions of fluorine (e.g. F₂) and/or oxygen) with M₂O being a metal oxide typically selected from Li₂O, Na₂O, K₂O, Ca₂O; 7) P₂O₅ - Al₂O₃ - MO - B₂O₃ with (for example) MO selected from: MgO, CaO, SrO, BaO, ZnO; 8) SiO₂ - BaO - M₂O with (for example) M₂O selected from Li₂O, Na₂O, K₂O, Ca₂O.

In preferred embodiments, the material of the primary substrate is selected from quartz glasses, in particular high quality quartz glasses, such as suprasil glass.

In another specific embodiment, the material of the primary substrate is selected from organic materials and glasses such as polymethylmethacrylate (PMMA), polycarbonate (PC), polycarbonate-comprising copolymers (e.g. PC-HT), styrene-methylmethacrylate-copolymer (SMMA), methacryl-acrylnitrile-butadien-styrene-copolymer (MABS), polystyrene (PS), styrene-acrylnitrile-copolymer (SAN), polymethacrylmethylimide (PMMI), cycloolefin-based polymers (COP), cycloolefin-based copolymers (COC), polyethersulfones (PES), polyetherimides (PEI), polmethylenepentene (TPX), polyamide 12 (PA 12), allyldiglycolcarbonate.

The material of the at least one graded layer deposited in step b) of the method of the invention may be principally any material, in particular any transparent material, which is capable to be removed by means of reactive ion etching (RIE). It may be further selected such that additionally a desired gradient of the refractive index is generated between the primary substrate and the thickness-graded layer(s) deposited thereon.

Since the material of the at least one graded layer deposited in step b) is at least partially removed during the subsequent etching treatment, this layer is also called "sacrificial" layer in the following description.

In a specific embodiment of the invention, the material of the at least one graded layer deposited in step b) is selected from the group comprising glass and quartz glass, in particular SiOx (with 1<x<2) and SiOxNy (with 1<x<2 and y/x+y in the range from 0 to 0.5 and with N/(N+O) from 0% to 50%). SiOxNy is preferably used if a desired gradient of the refractive index shall be generated between a primary substrate which is a quartz glass and the graded layer(s) deposited thereon.

The graded layer may be deposited by any suitable deposition method known in the art (e.g. physical vapor deposition (PVD), plasma enhanced chemical vapor deposition (PECVD) etc.).

A thickness gradient of the deposited layer in one or more directions can be achieved by relatively simple means, for example by tilting or rotating the substrate during the deposition process. By selecting the appropriate deposition methods and changing the tilting orientation or rotational speed during the deposition, one can create not only simple 2D gradients but also more complex 3D gradients with a linear or any other increase of layer thickness.

The dimensions of said at least one graded layer are not especially limited and may be adjusted as appropriate for the respective substrate and coating materials and applications. In particular, the thickness gradient(s) is/are selected such that the desired geometric parameters of the protruding nanostructures obtained after etching said graded layer can be obtained.

Typically, the thickness of the graded layer in one direction may vary in the range from 5 nm to 2000 nm, preferably from 20 nm to 1000 nm.

In step c) of the method according to the invention, a nanostructured etching mask is deposited onto the graded layer deposited in step b) above.

In a specific embodiment of the method according to the present invention, the nanostructured etching mask comprises an ordered array of nanoparticles or statistically distributed nanoparticles in which the spatial frequencies of the statistical distribution shows only contributions which are larger than the inverse of the wavelength of light (typically from 30 nm to 300 nm).

In a preferred embodiment of the invention, an ordered array of nanoparticles is provided on the substrate surface by means of a micellar diblock copolymer nanolithography technology, as described e.g. in EP 1 027 157 B1 and DE 197 47 815 A1. In micellar nanolithography, a micellar solution of a block copolymer is deposited onto a substrate, e.g. by means of dip coating, and under suitable conditions forms an ordered film structure of chemically different polymer domains on the surface, which inter alia depends on the type, molecular weight and concentration of the block copolymer. The micelles in the solution can be loaded with inorganic salts which, following deposition with the polymer film, can be oxidized or reduced to inorganic nanoparticles. Typically, nanoparticle arrangements manufactured with such a micellar nanolithography technology have a quasi-hexagonal pattern.

Principally, the material of the nanoparticles is not particularly limited and can comprise any material known in the prior art for such nanoparticles. Typically, this is a metal or metal oxide. A broad spectrum of suitable materials is mentioned in DE 10 2007 014 538 A1. Preferably, the material of the metal or the metal component of the nanoparticles is selected from the group made up of Au, Pt, Pd, Ag, In, Fe, Zr, Al, Co, Ni, Ga, Sn, Zn, Ti, Si and Ge, mixtures and composites thereof. Specific examples for a preferred metal oxide are titanium oxide, iron oxide and cobalt oxide. Preferred examples for a metal are gold, palladium and platinum and gold is particularly preferred.

The term "particle" as used here also comprises a "cluster", particularly as described and defined in DE 10 2007 014 538 A1 and DE 197 47 815 A1 and both terms can be used here interchangeably.

The BCML etching mask may be deposited on the substrate by any suitable method known in the art such as, e.g., dip coating or spin coating.

The BCML technology in combination with specific dip-coating techniques can be used to create nanoparticles (e.g. gold-dots) with different spacing and diameter on the graded sacrificial layer. By selecting the dipping-orientation of the substrate, the BCML gradient can either be parallel or in any orientation relative to a thickness gradient of the etchable material on the primary substrate.

The coated substrate is then RIE-etched to create nanostructures, typically nanopillars or nanocones, with different geometries within a single etching run. The gradient layer serves as a "sacrificial" layer. As the etching speed of the sacrificial layer is constant across the whole substrate (provided that a homogenous sacrificial layer is used, as typical), the different heights of the sacrificial layer result in "etching delays" of the underlying substrate and thus result in different heights of the protruding structures. Depending on the etching parameters, the resulting protruding structures can either be etched into the sacrificial layer alone, or be transferred into the primary substrate during consecutive etching steps.

Fig. 3 depicts a comparison of different methods to affect the geometry of antireflective nanopillars. A and B show the conventional method, using for example varying dip-coating speeds to create gradients of pillar distances. In combination with for example electroless deposition, this method also allows to create different particle sizes on a single substrate. These methods allow to control only one pillar parameter on a single substrate at a time. By combining these methods with an additional graded sacrificial gradient layer (C), one can control two or more pillar geometry parameters on a single substrate with a single RIE step (D).

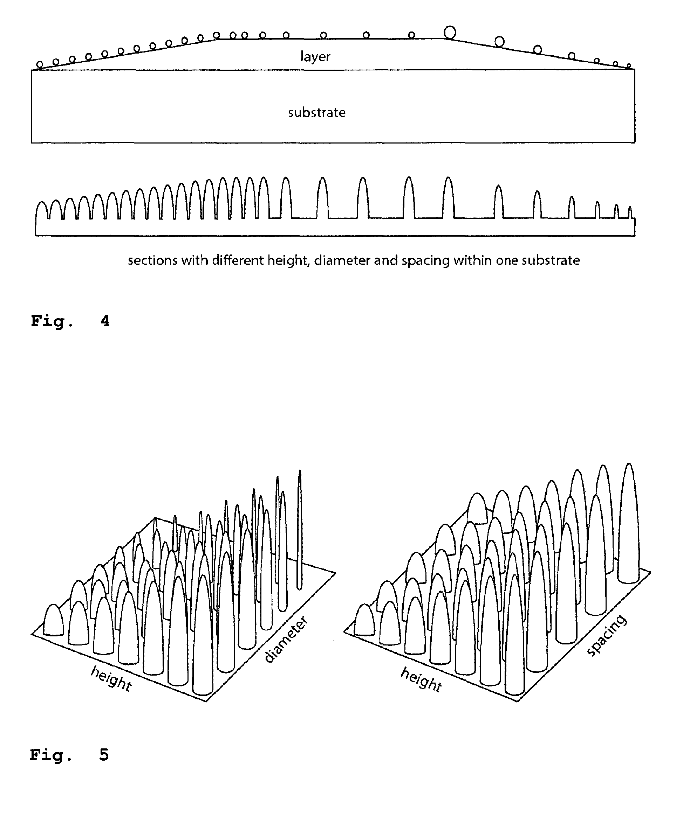

Fig. 4 shows that a surface covered with a graded sacrificial layer and a combination of different nanoparticle sizes and distances (top) will result in a substrate structured with a complex pattern of pillars with different geometries (bottom).

Suitable methods for plasma etching or reactive ion etching are principally known in the art (see, e.g. DE 10 2007 014 538 A1 and Lohmüller et al. (NANO LETTERS 2008, Vol. 8, No. 5, 1429-1433).

The etching step d) of the method of the invention can comprise one or several treatments with the same etching agent and/or with different etching agents. The etchant can basically be any etchant known in the prior art and suitable for the respective substrate surface. Preferably, the etchant is selected from the group of chlorine gases, e.g. Cl₂, BCl₃ and other gaseous chlorine compounds, fluorinated hydrocarbons, e.g. CHF₃, CH₂F₂, CH₃F, fluorocarbons, e.g. CF₄, C₂F₈, oxygen, argon, SF₆ and mixtures thereof.

Preferably, the etching comprises at least one treatment with a mixture of Ar/SF₆/O₂ or Ar/SF₆ as etchant and at least one treatment with a mixture of Ar/CHF₃ as etchant.

For example, a combination of a first etching step with a mixture of Ar/SF₆ as etchant and a second etching step with a mixture of Ar/SF₆/O₂ may be used to produce pillar-shaped nanostructures from a SiOx substrate. A combination of a first etching step with a mixture of Ar/SF₆/O₂ and a second etching step with a mixture of Ar/CHF₃ may be used to produce conical nanostructures from a SiOx substrate.

Typically, each etching step is carried out for a period in the range of 5 s, 10 s or 30 s to 10 min., 30 min. or 60 min., preferably in the range from 10 s to 60 min., more preferred in the range from 60 s to 120 s.

The duration of the entire etching treatment typically lies in the range of 10 s to 60 minutes, preferably in the range from 1 to 15 minutes or 1 to 30 minutes.

Typically, the obtained protruding nanostructures have a mean diameter in the range of 10-100 nm, preferably 10-30 nm, and a mean height of 10-1600 nm, preferably 250-500 nm. In the case of conical structures, the diameter data refer to the thickness at half height. The average spacings of the nanostructures are preferably in a range from 15 nm to 250 nm.

A typical height gradient of the protruding nanostructures may comprise nanostructures having a height in the range from 20 nm to 800 nm.

A typical diameter gradient of the protruding nanostructures may comprise nanostructures having a diameter in the range from 10 nm to 30 nm.

A typical spacing gradient of the protruding nanostructures may comprise nanostructures having a mean spacing in the range from 50 nm to 120 nm.

For some applications it is preferred that the nanoparticles used as an etching mask have a predetermined two-dimensional geometric arrangement on the substrate surface. Such arrangement has predetermined minimum or average particle spacings as a characteristic, wherein these predetermined particle spacings can be the same in all regions of the substrate surface or various regions can have different predetermined particle spacings. A geometric arrangement of this type can fundamentally be realized with any suitable method of the prior art, micellar nanolithography in particular, as explained in more detail above.

Some embodiments of the method according to the present invention involve at least one further processing step of a mechanical treatment, such as sonication, of the protruding structures generated in the course of the etching step.

In a specific embodiment of the present invention, the protruding structures generated in the graded layer deposited in step b) are used as an etching mask and gradients of the protruding structures corresponding to the protruding structures of the graded layer above are generated in the primary substrate and the layer(s) above said primary substrate are removed in part or completely.

This further etching treatment may be accomplished by means of reactive ion beam etching (RIBE), chemically assisted ion beam etching (CAIBE), reactive ion etching (RIE) or inductive coupled plasma (RIE-ICP) as appropriate for the respective substrate layer.

Using the above multi-step-etching process enables to achieve nanostructures on or in the primary substrate which were not obtainable by a direct reactive ion etching treatment of the primary substrate with the BCML pattern.

A nanostructured primary substrate which is free from any coating layers is mechanically more stable, since no coating layers are potentially detachable under conditions of mechanical or thermal stress. Also, if the coating layers are completely removed in the final etching step, it is possible to use toxic or non- biocompatible intermediate layers and still obtain a biocompatible final product. This allows more flexibility in conducting the method of the invention.

A further aspect of the present invention relates to the nanostructured substrate obtainable by the method as outlined above.

The substrate with a nanostructured surface according to the present invention comprises an array of protruding nanostructures, in particular nanopillars or nanocones, wherein the protruding nanostructures comprise at least 2, preferably 3, gradients of geometric parameters of the protruding nanostructures on a single substrate.

More specifically, the geometric parameters are selected from the group comprising the height, diameter and spacing of the protruding nanostructures.

In a preferred embodiment of said nanostructured substrate, each of the protruding nanostructures simultaneously represents an element of 3 continuous gradients of the height, diameter and spacing of said protruding nanostructures.

The nanostructured substrate may be a composite substrate, wherein the protruding structures are composed of the material of the "sacrificial" graded layer(s) deposited on the primary substrate (optionally capped with nanoparticles) and, optionally, also of material of the primary substrate.

In an alternative embodiment, the nanostructured substrate is the primary substrate and the protruding structures essentially consist of the material of the primary substrate.

Preferably, the nanostructured composite substrate or primary substrate is an optical element and the protruding structures form an anti-reflective surface structure on the optical element.

In a more specific embodiment of said composite substrate or optical element, the protruding structures have a predetermined two-dimensional geometric arrangement, in particular a hexagonal arrangement, or are statistically distributed such that the spatial frequencies of the statistical distribution shows only contributions which are larger than the inverse of the wavelength of light (typically in a range from 30 nm to 300 nm).

In one specific embodiment, the material of the primary substrate is selected from organic and inorganic glasses as described above.

In preferred embodiments, the material of the primary substrate is selected from quartz glasses, in particular high quality quartz glasses, such as suprasil glass.

Preferably, the material of the graded layer or sacrificial layer of the composite material is selected from the group comprising glass, in particular SiOx and SiOxNy, SiOx (with 1<x<2) and SiOxNy (with y/x+y in the range from 0 to 0.5 and N/(N+O) from 0% to 50%).

The products of the method according to the invention offer a wide range of application options in the fields of semiconductor technology, optics, sensor technology and photovoltaics.

A few non-limiting examples for this are the use in optical devices, particularly optical elements such as lenses, diffraction gratings and other refracting or diffractive structures, sensors, particularly CCD sensors and solar cells.

A particularly preferred application relates to the use of such nanostructured gradient substrates as "single-piece filter substrates", combining various geometries of the protruding nanostructures on a single substrate with very fine transitions between each geometry. By determining the position on the filter where the light passes, one can then utilise a single substrate to filter almost all wavelengths without replacing the filter.

Examples for applications using such nanostructure (in particular nanopillar or nanocone) gradient filters (NGF) include systems with movable filters (Fig. 6), rotating mirrors (Fig. 7) and prism filters (Fig. 8).

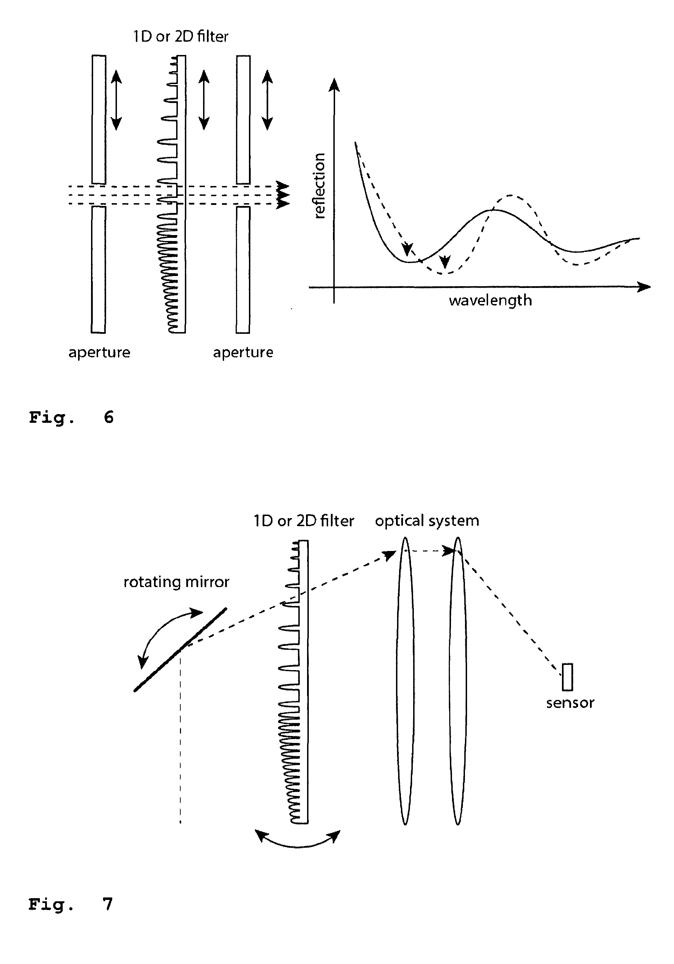

In Fig. 6, a beam of light passes through one aperture, a nanostructure gradient filter (NGF) and another aperture. By either moving the apertures relative to the NGF or the NGF relative to the filter, the beam passes through a pre-selected region of the nanostructured substrate. The transmitted signal shows a corresponding reflection minimum (arrow), which can be shifted by moving either the apertures or the NGF.

Fig. 7 shows an embodiment wherein a rotating mirror is used to deflect a beam of light towards a pre-selected region of a NGF. The NGF can be rotated/moved to allow for an additional degree of freedom. An optical system is then used to deflect the resulting optical signal onto a sensor or into a subsequent optical system.

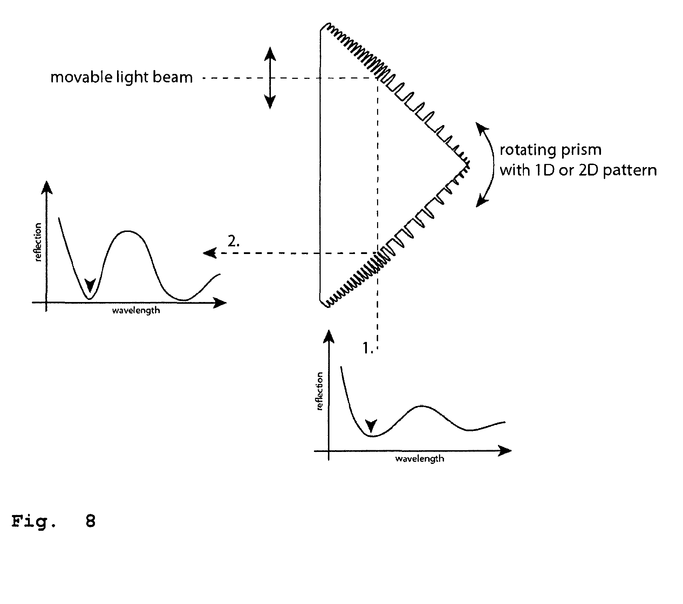

In Fig. 8, a movable light-source projects a beam of light into a prism with at least one side covered by a NGF. The position of the light-source determines the position the beam hits on the NGF. Within the symmetrical prism, the beam is reflected onto the next NGF, where the Fabry-Pérot effect amplifies the anti-reflective properties.

Compared to conventional methods and filter systems, the method of the present invention and the nanostructure gradient filters (NGF) obtainable therewith provide several unique advantages:
- Various geometries of the protruding nanostructures are present on the same single substrate.
- Protruding nanostructures having 2 or more gradients of their characteristic geometric parameters can be simultaneously generated by a single etching treatment.
- Gradients can be easily controlled and adjusted according to the optical requirements.
- High thermal stability and energy transmission possible, thus allowing excellent use for high energy laser applications.
- Possibility to tune the required reflection minimum to a specific wavelength.
- No need to replace the filter to adjust the transmission maximum or reflection minimum at different wavelengths.
- Optical systems with NGF can be designed to have less movable parts, which is ideal for demanding applications (high mechanical stress, oscillations, challenging environments) or low cost operation.

### Brief description of the figures

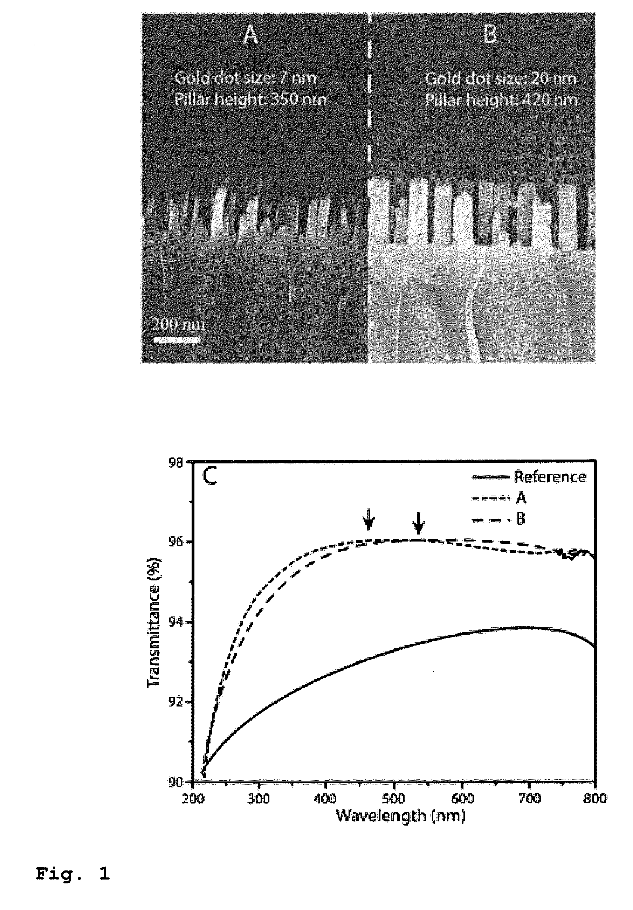

**Fig. 1** shows the effect of different moth-eye structures as present in different areas on a single graded substrate of the invention. The transmission of the nanostructured substrates (broken lines) is significantly higher than the transmission of the plain substrate (continuous line). Different pillar geometries (A/B) result in different transmission maxima and reflection minima, respectively (arrows).
**Fig. 2** shows examples of a 2D (top) or 3D (bottom) gradient sacrificial layer formed on top of a primary substrate.
**Fig. 3** shows a comparison of different methods to affect the geometry of antireflective nanopillars.
**Fig. 4** shows a surface covered with a graded sacrificial layer and a combination of different nanoparticle sizes and distances (top) and the resulting etched substrate structured with a complex pattern of pillars with different geometries (bottom).
**Fig. 5** shows a single substrate covered by nanopillars with different height and diameter (left) and different height and spacing (right).
**Fig. 6** shows the basic principle of an optical device wherein a beam of light passes through one aperture, a nanostructure gradient filter (NGF) and another aperture.
**Fig. 7** shows the basic principle of an optical device wherein a rotating mirror is used to deflect a beam of light towards a pre-selected region of a NGF.
**Fig. 8** shows the basic principle of an optical device wherein a movable light-source projects a beam of light into a prism with at least one side covered by a NGF.

The following examples are used for more in depth explanation of the present invention, without limiting the same thereto, however. It will be evident for the person skilled in the art that variations of these conditions in dependence of the specific materials used may be required and can be determined without difficulty by means of routine experiments.

### EXAMPLE 1

### Creation of a plurality of nanostructure gradients on the same single substrate

### 1. Providing a composite substrate

A primary substrate, such as suprasil glass, is coated with at least one layer of an easily RIE etchable material such as SiO₂ by means of sputter coating (UHV system; 99.995% SiO₂ target, 3.00 inch diameter, 0.125 inch thickness, room temperature sputter at 150W RF power with O₂ and Ar at 2*10⁻³ mbar, base pressure: 10⁻⁶ mbar).

By slowly tilting the substrate during the deposition process, a gradient with varying thickness is deposited onto the substrate. By selecting the appropriate deposition methods and changing the tilting orientation during the deposition, it is possible to create simple 2D gradient or more complex 3D gradients (compare Fig. 2) with a linear or any other increase of layer thickness.

### 2. Providing an array of nanoparticles on the substrate surface

The surface of the graded "sacrificial" layer of the composite substrate was coated with gold nanoparticles in a defined arrangement by means of micellar nanolithography. In this step, one of the protocols described in EP 1 027 157 B1, DE 197 47 815 A1 or DE 10 2007 017 032 A1 can be followed.

The method involves the deposition of a micellar solution of a block copolymer (e.g. polystyrene(n)-b-poly(2-vinylpyridine(m)) in toluene) onto the substrate, e.g. by means of dip or spin coating, as a result of which an ordered film structure of polymer domains is formed on the surface. The micelles in the solution are loaded with a gold salt, preferably HAuCl₄, which, following deposition with the polymer film, can be reduced to the gold nanoparticles.

The reduction can take place chemically, e.g. with hydrazine, or by means of energy-rich radiation, such as electron radiation or light. Optionally, after or at the same time as the reduction, the polymer film can be removed (e.g. by means of plasma etching with Ar-, H- or O-ions). Thereafter, the substrate surface is covered with an arrangement of gold nanoparticles.

By using the BCML technology in combination with dip-coating techniques it is possible to create gold-dots with different spacing and diameter on the SiO₂ sacrificial layer (compare Fig.3). By selecting the dipping-orientation of the substrate, the BCML gradient can either be parallel or in any orientation relative to the SiO₂ gradient on the substrate.

### 3. First Etching

Subsequently, the etching of the substrate surface covered with gold nanoparticles took place in a desired depth. A "reactive ion etcher" from Oxford Plasma, device: PlasmaLab 80 plus was used to this end. Other devices known in the prior art are likewise fundamentally suitable, however. The etching consisted of two treatment steps with various etchants which were carried out several times one after the other.

The following protocol was used to create conical nanostructures:

### Step 1:

A mixture of Ar/SF₆/O₂ in the ratio 10:40:8 (sccm) was used as etchant (process gas).
Pressure: 50 mTorr
RF power: 120 W
ICP power: 0 W
Time: 60 s

### Step 2:

Etchant: Ar/CHF₃:40:40
Pressure: 50 mTorr
RF power: 120 W
ICP power: 20 W
Time: 20 s

These 2 steps were carried out alternately 8 times.

Alternatively, the following protocol was used to create pillar-shaped nanostructures:

### Step 1:

A mixture of Ar/SF₆ in the ratio 40:40 (sccm) was used as etchant (process gas).
Pressure: 50 mTorr
RF power: 120 W
ICP power: 0 W
Time: 60 s

### Step 2:

Etchant: Ar/CHF₃:40:40
Pressure: 50 mTorr
RF power: 120 W
ICP power: 20 W
Time: 20 s

These 2 steps were carried out alternately 8 times.

The total duration of the etching treatment varied depending on the desired depth of the etching within about 1-15 minutes. As a result, column-like or conical nanostructures were obtained, which still can show gold nanoparticles on their upper side.

### 4. Second Etching

The nanostructures created on the graded layer as outlined above can further be used as an etching mask for transferring said nanostructures into the primary substrate layer by means of RIE or reactive ion beam etching (RIBE). Compared to the RIE process described above, the RIBE process is less selective and can etch substrates, which cannot be etched using RIE.

Reactive ion beam etching (RIBE) uses an energetic, broad beam collimated and highly directional ion source to physically mill material from a substrate mounted on a rotating fixture with adjustable tilt angle. In contrast to ion beaming (IBE), in the RIBE process reactive ions are incorporated in whole or in part in the etching ion beam.

The ion sources used are "gridded" ion sources, e.g. of the Kaufman type or microwave electron cyclotron resonance (ECR). The etching process involves the control of the ion incident angle and a separate control of the ion flux and ion energy. Typical reactive and inert gases used for RIBE are Ar, N₂, O₂, CHF₃ CF₄ and SF₆.

The RIE or RIBE process directly transferred the nanostructure of the mediating sacrifical layer into the primary substrate.

### EXAMPLE 2

### Characterisation of nanostructured composite or primary substrates

Suprasil samples with a gradient SiO₂ layer and electroless treated BCML patterns were etched on one side using a RIE process as described above. Wavelength-dependent transmittance was then measured using a spectrometer set-up with a beam size of ∼1mm. After the measurements the samples were cleaved to take SEM pictures of the pillar cross sections. Fig. 1A shows the geometry of the pillar structure on one side of the sample (∼42nm diameter, 350nm height, Fig. 1B on the opposite side of the same sample (∼78nm diameter, 420nm height). Fig. 1C shows the corresponding improved overall transmittance (compared to a plain suprasil substrate) and the shift of the transmission maximum.

## Claims

1. A method for producing a nanostructured substrate comprising an array of protruding nanostructures, in particular nanopillars, which method comprises at least the following steps:
a) providing a primary substrate;
b) depositing at least one layer of a material capable to be removed by means of reactive ion etching (RIE) onto said primary substrate which layer comprises a predetermined gradient of its thickness;
c) depositing a nanostructured etching mask onto the graded layer deposited in step b);
d) generating protruding structures, in particular nanopillars, in the graded layer deposited in step b) by means of reactive ion etching (RIE), wherein simultaneously at least 2, preferably 3, predetermined continuous gradients of geometric parameters of the protruding structures are generated on the same substrate.

2. The method according to claim 1, wherein the layer deposited in step b) comprises a 2-dimensional or 3-dimensional gradient of its thickness.

3. The method according to claim 1 or 2, wherein the geometric parameters are selected from the group comprising the height, diameter and spacing of the protruding structures.

4. The method according to any one of claims 1-3, wherein the nanostructured etching mask comprises an array of nanoparticles which is provided by means of micellar diblock or multiblock copolymer nanolithography.

5. The method according to any one of claims 1-4, wherein the etching comprises at least one treatment with an etchant which is selected from the group of chlorine, gaseous chlorine compounds, fluorinated hydrocarbons, fluorocarbons, oxygen, argon, SF₆ and mixtures thereof.

6. The method according to Claim 5, wherein the etching comprises at least one treatment with a mixture of Ar/SF₆/O₂ or Ar/SF6 as etchant and at least one treatment with a mixture of Ar/CHF₃ as etchant.

7. The method according to any one of Claims 1-6, wherein each etching treatment is carried out for a period in the range of 30 s to 60 min.

8. The method according to any one of claims 1-7 which further comprises a mechanical treatment, such as sonication, of the protruding structures generated.

9. The method according to any one of claims 1-8 which comprises a further etching treatment by means of reactive ion beam etching (RIBE), chemically assisted ion beam etching (CAIBE), reactive ion etching (RIE) or inductive coupled plasma (RIE-ICP), wherein the protruding structures generated in the graded layer deposited in step b) are used as an etching mask and gradients of the protruding structures corresponding to the protruding structures of the graded layer above are generated in the primary substrate and the layer(s) above said primary substrate are removed in part or completely.

10. A nanostructured substrate comprising an array of protruding nanostructures, in particular nanopillars, wherein the protruding nanostructures comprise at least 2, preferably 3, continuous gradients of geometric parameters of the protruding nanostructures on a single substrate.

11. The nanostructured substrate according to claim 10, wherein the geometric parameters are selected from the group comprising the height, diameter and spacing of the protruding nanostructures.

12. The nanostructured substrate according to claim 11, wherein each of the protruding nanostructures simultaneously represents an element of 3 continuous gradients of the height, diameter and spacing of said protruding nanostructures.

13. The nanostructured substrate according to any one of claims 9-12 which is an optical element, in particular an optical filter, and wherein the protruding structures form an anti-reflective surface structure on the optical element.

14. A device, in particular optical device, comprising the nanostructured substrate according to any one of claims 10-13.

15. A use of the nanostructured substrate or the device according to any one of claims 10-14 in the fields of semiconductor technology, optics, sensor technology and photovoltaics.

16. The use according to claim 15 in optical devices, sensors, particularly CCD sensors and solar cells.
